# EUROPÄISCHE PATENTSCHRIFT

(11) **EP 2 801 830 B1**
(45) Veröffentlichungstag und Bekanntmachung des Hinweises auf die Patenterteilung: **30.11.2016**
(21) Anmeldenummer: 13166945.9
(22) Anmeldetag: 08.05.2013
(51) Int. Cl.: G01Q 70/16, B81C 1/00

(54) **Waferverbund mit Sonden für ein Rasterkraftmikroskop**
Wafer with probes for a scanning force microscope
Plaquette dotée de sondes pour un microscope à force atomique à balayage

(43) Veröffentlichungstag der Anmeldung: 12.11.2014
(73) Patentinhaber: NanoWorld AG, 2002 Neuchâtel (CH)
(72) Erfinder: Detterbeck, Manfred, CH-8280 Kreuzlingen (CH); Burri, Mathieu, CH-2515 Preles (CH); Aeschimann, Laure, CH-3226 Treiten (CH); Sulzbach, Thomas, 91085 Weisendorf (DE)
(74) Vertreter: Klocke, Peter

(56) Entgegenhaltungen:
- DE-A1- 19 622 701
- US-A1- 2007 264 803

## Beschreibung

Die Erfindung betrifft einen Waferverbund mit Sonden für ein Rasterkraftmikroskop, worin eine Vielzahl von Sonden, die jeweils ein Halteelement und einen von dem Halteelement abstehenden und eine Abtastspitze tragenden Federbiegebalken aufweisen, in einem regelmäßig strukturierten Waferrahmen herausbrechbar angeordnet sind, wobei zumindest die Haltelemente aus einem Siliziumwafer herausgearbeitet und die Sonden über die Halteelemente direkt oder indirekt mit dem Waferrahmen über mindestens eine Halterung verbunden sind, die eine Sollbruchstelle zum mechanischen Lösen der Sonden von dem die Sonden umgebenden Waferrahmen aufweist.

Sonden für die Rasterkraftmikroskopie, auch AFM-Sonden genannt, werden in der Regel auf der Grundlage von einkristallinen Siliziumscheiben (Wafern) mit Durchmessern von üblicherweise 100 oder 150 mm hergestellt. Dabei können Hunderte von Sonden parallel gleichzeitig in einem Fertigungsablauf produziert werden, wobei die Kosten des Fertigungsverfahrens im wesentlichen unabhängig von der Anzahl der Sonden auf dem Wafer sind. Eine Erhöhung der Anzahl von Sonden pro Wafer führt daher zu einer Kostenreduzierung pro Sonde. Eine weitere Kostenreduzierung für derartig hergestellte Sonden ist prinzipiell mit der Verwendung von größeren Siliziumscheiben, beispielsweise von Wafern mit einem Durchmesser von 200 oder 300 mm möglich. Für die Verwendung von Siliziumscheiben mit derartigem Durchmesser sind jedoch Investitionen in neue Maschinen notwendig, die bei den für AFM-Sonden üblichen Stückzahlen in der Regel die Einsparung übertreffen und damit unwirtschaftlich sind.

Sonden für ein Rasterkraftmikroskop werden aufgrund des sehr empfindlichen mikromechanischen Federbiegebalkens, um eine Beschädigung auszuschließen, nicht wie andere elektronische Bauelemente durch Sägen vereinzelt. Die Sonden werden nach dem Herausarbeiten aus dem Siliziumwafer stattdessen mechanisch aus dem Waferverbund herausgebrochen. Dafür sind die Sonden über eine oder zwei Verbindungen (Brücken) mit dem Waferrahmen leicht lösbar verbunden. Beim Layout für den Waferverbund wird insbesondere großes Augenmerk auf einen einfachen und sicheren Herstellungsprozess mit einer leichten Entnahmemöglichkeit der Sonden gelegt. Zum Stand der Technik von Halbleiterverbünden, die beispielsweise Sonden für die Rasterkraftmikroskopie aufweisen, wird beispielhaft auf die Druckschriften US 2008/011 65 33 A1 und EP 1 270 504 B1 und DE 196 22 701 A1 verwiesen.

Die EP 1 270 504 B1 offenbart einen Waferverbund mit Halbleiterbauelementen, bei dem die Bauelemente mit einem Rahmen des Siliziumwafers über jeweils eine Halterung verbunden und aus demselben Siliziumwafer herausgearbeitet sind, wobei die Halterung einseitig das jeweilige Halbleiterbauelement mit dem Waferrahmen verbindet. Die Halterung besteht dabei aus einem Balken, der sich ausgehend von dem Waferrahmen im wesentlichen orthogonal hin zu dem jeweiligen Bauelement erstreckt. Die Herstellung dieser Halterungen, die allein der Fixierung der Bauelemente an dem Rahmen dienen, erfolgt durch fotolithografische Strukturierung einer Wafervorderseite mit anschließenden trocken- und/oder nasschemischen Ätzprozessen zur Formgebung. Das Freilegen der Bauelemente und der Halterungen, d. h. die Trennung der Bauelemente vom Rahmen, erfolgt durch fotolithografische Strukturierung der Wafervorderseite und/oder einer Waferrückseite mit anschließenden trocken- und/oder nasschemischen Ätzprozessen zur Formgebung. Das Bauelement selbst wird dann aus dem Waferrahmen durch Ausüben von Druck auf das Bauelement, bis es zum Brechen der Halterung kommt, herausgebrochen. Um das Herausbrechen zu vereinfachen, weist die Halterung des bekannten Waferverbundes eine Sollbruchstelle zum mechanischen Lösen des Bauelementes von dem Waferrahmen auf. Insbesondere ist die Halterung durch eine flächige Verdickung des Rahmens und durch eine Grube zwischen dem Rahmen und dem Halbleiterbauelement gebildet. Dabei ist die Grube als Trennlinie V-förmig ausgeführt und bildet die Sollbruchstelle.

Die DE 196 22 701 A1 lehrt eine Abtast- und Prüfspitze, bestehend aus einem Mikrobalken (Cantilever) mit einer Diamantspitze für den Einsatz in Abtastsystemen und Rastersondenmikroskopen, wobei die Diamantspitze und Mikrobalken eine technologische Einheit derart bilden, dass die Diamantspitze als Ganzes unter Verwendung von Plasmadepositionsprozessen direkt auf dem Balken aufgewachsen ist. Die Herstellung der Haltelemente und der Cantilever erfolgt mit Hilfe lithographischer Mikrostrukturierungstechniken. Zuerst erfolgt das Ätzen einer wenige Mikrometer dicken Membran aus Silizium, wobei die massiven Halteelemente und und dünnere Brücken zwischen den Chips stehen bleiben. Aus der Membran werden später die Cantilever gebildet, wobei die Dicke der Membran der Cantileverdicke entspricht. Anschließend werden auf der ungeätzten Waferseite dann durch ein additives oder subtraktives Verfahren die Diamantspitzen integriert. Schließlich werden das Halteelement und der Cantilever der Chips durch einen Lack abgedeckt und die restliche Silizium-Membran durch einen weiteren Ätzschritt entfernt, so dass der Chip freisteht und nur noch an den dünnen Brücken (Sollbruchstellen) gehalten ist.

Ausgehend von dem vorstehend genannten Stand der Technik liegt der Erfindung die Aufgabe zugrunde, eine Möglichkeit vorzuschlagen, die eine höhere Packungsdichte der Sonden des Waferverbundes des Siliziumwafers erlaubt.

Diese Aufgabe wird erfindungsgemäß durch einen Waferverbund mit den Merkmalen des Patentanspruchs 1 sowie mit einem Verfahren zur Herstellung eines derartigen Waferverbundes mit den Merkmalen des diesem nebengeordneten Patentanspruchs 9 gelöst.

Danach weisen bei dem erfindungsgemäßen Waferverbund die Halteelemente überwiegend einkristallines Silizium auf, wobei die Halteelemente von jeweils mindestens zwei nebeneinander angeordneten Sonden zur Bildung von Sondenstreifen über eine direkte Anbindung miteinander verbunden sind, die eine Sollbruchstelle zum Vereinzeln der Sonden der Sondenstreifen aufweisen. Unter überwiegend wird in diesem Zusammenhang wie üblich verstanden, dass die Haltelemente zumindest zu 50 Prozent aus einkristallinem Silizium bestehen. Dabei sind die Halteelemente der äußeren Sonden der Sondenstreifen über Halterungen mit dem Waferrahmen verbunden, die ebenfalls eine Sollbruchstelle zum Herausbrechen der Sondenstreifen aus dem Waferrahmen aufweisen.

Die Sonden der Sondenstreifen weisen je ein Halteelement und einen von dem Halteelement abstehenden eine Abtastspitze tragenden Federbiegebalken auf, wobei die Sonden über die Halteelemente direkt oder indirekt mit dem Waferrahmen über mindestens eine Halterung verbunden sind, die eine Sollbruchstelle zum mechanischen Lösen der Sonden von dem Waferrahmen aufweist. Die Sollbruchstellen zwischen den einzelnen Sonden der Sondenstreifen bzw. der randseitigen Sonden der Sondenstreifen und dem Waferrahmen sind Dünnstellen des Waferverbundes. An diesen Stellen ist die Dicke des Siliziumwafers gegenüber der des Waferrahmens und der Haltelemente durch Nachbearbeitung reduziert ausgebildet, sodass der Waferverbund dort bei entsprechender Krafteinwirkung bevorzugt bricht. Damit sind die Sondenstreifen besonders einfach und ohne Beschädigung aus dem Waferrahmen herausbrechbar und die Sonden der Sondenstreifen voneinander problemlos durch Abbrechen vereinzelbar. Die Sollbruchstellen der Halterungen und/oder der Anbindungen können jeweils von Gruben bzw. Kerben gleicher oder unterschiedlicher Tiefe gebildet sein, die auf einer und/oder unterschiedlichen Seiten des Silizuimwafers ausgebildet sind. Dabei können jeweils eine oder mehrere nebeneinander angeordnete Gruben oder Kerben, bevorzugt mit unterschiedlicher Tiefe und/oder Breite, eine Sollbruchstelle bilden. Beispielsweise können Doppelgruben oder -kerben dabei auch unterschiedlich tief und/oder breit ausgeführt sein. Ein erfindungsgemäßer Waferverbund mit Sondenstreifen kann auch mit anderen Konzepten für die Sollbruchstellen realisiert sein, beispielsweise mit als Brückenstege ausgebildeten Halterungen und/oder Anbindungen, an denen Sollbruchstellen vorgesehen sind, die gleich oder zumindest ähnlich wie vorstehend beschrieben ausgebildet sind.

Kerngedanke der Erfindung ist es, eine Erhöhung der Anzahl von Sonden pro Wafer ohne eine Änderung der Wafergröße durch eine kompaktere Anordnung der Sonden auf dem Wafer zu erzielen. Die Erhöhung der Anzahl von Sonden auf einem Wafer wird erfindungsgemäß dadurch erreicht, dass die Sonden nicht einzeln, wie beim Stand der Technik, an dem umgebenden Waferrahmen befestigt sind, sondern in Streifen, innerhalb denen die Sonden direkt miteinander verbunden sind. Die Verbindung der Sonden der Sondenstreifen ist dabei als direkte Anbindung der Halteelemente aneinander unter Ausbildung von Sollbruchstellen zwischen den Halteelementen ausgeführt. Auf diese Weise können die Sonden auf einfache Art und Weise voneinander ohne Beschädigung getrennt werden. Die Sondenstreifen, die eine gleiche oder unterschiedliche Länge aufweisen können, sind in gleicher Weise über zwei Halterungen, von denen jeweils eine an jedem Ende der Sondenstreifen angeordnet ist, an dem umgebenden Waferrahmen befestigt. Der Waferrahmen sorgt für die notwendige Stabilität des gesamten Waferverbundes während der Fertigung der Sonden. Damit können die jeweiligen Sondenstreifen problemlos ohne Beschädigung aus dem Waferverbund entnommen werden, bevor die einzelnen Sonden aus dem Sondenstreifen zum Vereinzeln der Sonden abgebrochen werden. Um die Reihenfolge der Sonden-Entnahme aus dem Waferverbund zu begünstigen, ist es von Vorteil, die Verbindung zwischen den äußersten Sonden jedes Sondenstreifens und dem Waferrahmen, d. h. die Halterungen so auszulegen, dass deren Sollbruchstellen leichter brechen als die Sollbruchstellen der Anbindungen der Sonden untereinander. Dies kann zum Beispiel durch eine geringere Restdicke der Halterungen gegenüber der der Anbindungen und/oder durch ein zusätzliches dünneres Zwischenelement erreicht werden.

Vorzugsweise weisen die Halterungen und/oder die Anbindungen V-förmige Kerben als Sollbruchstellen auf. Dabei ist die Brechkraft der Sollbruchstellen allein von der Tiefe und/oder der Breite der Kerben abhängig.

Die Realisierung der Sondenstreifen, mit mindestens zwei direkt miteinander verbundenen Sonden, die V-förmige Kerben als Sollbruchstellen zwischen den einzelnen Sonden und V-förmige Kerben als Sollbruchstellen zwischen den Sondenstreifen und dem Waferrahmen aufweisen, kann durch anisotropes nasschemisches Siliziumätzen zum Beispiel mit einer Kaliumhydroxidlösung erreicht werden. Dieses Ätzverfahren ist sehr selektiv bezüglich der Kristallorientierung des Siliziums und weist eine praktisch verschwindende Ätzrate senkrecht zu den {111}-Flächen des Siliziumkristalls auf. Bei entsprechend gewählter Maskierung und Kristallorientierung des Ausgangsmaterials stoppt daher die Ätzung zwischen den Halteelementen der Sonden bzw. dem Waferrahmen, wenn zwei {111}-Flächen aufeinander treffen. Dadurch entsteht eine sehr exakt definierte V-förmige Kerbe zwischen den Halteelementen eines Sondenstreifens bzw. den äußeren Halteelementen am Rand des Sondenstreifens und dem Waferrahmen.

Entsprechend weisen bei einer bevorzugten Ausführungsform der Erfindung die Kerben Kerbenflanken auf, die von {111}-Ebenen des Siliziumwafers gebildet sind. Die Tiefe solcher Kerben bzw. die daraus resultierende Restdicke des Materials an der Sollbruchstelle lässt sich exakt über die Breite der Öffnung einstellen. Durch die Selbstlimitierung der Ätzung in den V-förmigen Kerben kann die Ätzung ohne wesentlichen Einfluss auf die Funktionalität der Verbindung zwischen den Halteelementen fortgesetzt werden, um die Halteelemente vollständig aus dem Ausgangsmaterial herauszuarbeiten und die Federbalken freizulegen. Um zu Erreichen, dass die Sollbruchstellen zwischen den jeweiligen Sondenstreifen und dem Waferrahmen leichter brechen als die Sollbruchstellen zwischen den jeweiligen Sonden der Sondenstreifen, sind die Kerben der Halterungen bei einer bevorzugten Ausführungsform der Erfindung tiefer und breiter als die Kerben der Anbindungen ausgeführt.

Um die vorhandene Fläche eines runden Siliziumwafers optimal ausnutzen zu können, müssen die Sondenstreifen zumindest teilweise eine unterschiedliche Anzahl von Sonden aufweisen. Die in unterschiedlicher Anzahl zu Gruppen zusammengefassten Halteelemente mit Federbiegebalken bedingen dabei eine unterschiedliche Länge der Sondenstreifen, die vorzugsweise derart ausgebildet ist, dass die Sondenstreifen bei geschickter Anordnung, neben- und/oder hintereinander, die kreisrunde Fläche des Siliziumwafers optimal ausnutzen. Dazu sind die Sondenstreifen des Siliziumwafers vorzugsweise mit geringem seitlichem Abstand parallel zueinander in dem Waferverbund angeordnet. Dabei ist es sinnvoll, die Länge der Sondenstreifen, d. h. die Anzahl der direkt miteinander verbundenen Sonden zu begrenzen, um eine ausreichende mechanische Stabilität des gesamten Waferverbundes beim Fertigungsprozess zu gewährleisten.

Entsprechend weist der erfindungsgemäße Waferverbund bei einer bevorzugten Ausführungsform nicht nur in Querreihen nebeneinander angeordnete Sondenstreifen unterschiedlicher Länge, sondern zudem auch noch sich in Längsrichtung hintereinander erstreckende Sondenstreifen, die eine Längsreihe bilden, auf. Die Längsreihen sind dann durch einen Zwischensteg des Waferrahmens voneinander in Längsrichtung getrennt. Der oder die Zwischenstege erstrecken sich vorzugsweise orthogonal zu den Sondenstreifen, wobei die Sondenstreifen mit dem jeweiligen Zwischensteg über eine Halterung verbunden sind, die wie vorstehend beschrieben ausgeführt ist.

Für die Qualitätskontrolle bei der Fertigung von Sonden für ein Rasterkraftmikroskop ist es oft notwendig, schon während der Fertigung einzelne Sonden zu entnehmen, um diese in geeigneter Weise kontrollieren zu können. Bei einer bevorzugten Ausführungsform der Erfindung weist daher der Waferverbund neben einer Anzahl von Sondenstreifen auch mindestens eine einzelne Sonde, bevorzugt mehrere einzelne Sonden auf, die mit dem Waferrahmen über eine Halterung mit Sollbruchstelle einfach lösbar verbunden sind. Das Halteelement solcher Einzelsonden ist nur mit dem Waferrahmen oder einem Zwischensteg verbunden. Diese Einzelsonden können dann als Testsonden gezielt entnommen werden, ohne einen Sondenstreifen von direkt miteinander verbundenen Sonden herauszubrechen oder zu beschädigen.

Die Erfindung ist auf alle Sonden anwendbar, deren Halteelemente überwiegend aus einkristallinem Silizium bestehen. Dabei können der Federbiegebalken und die Tastspitze aus dem gleichen Material wie das Halteelement gefertigt sein oder aus einer Dünnschicht bestehen. Das Halteelement der Federbiegebalken und die Abtastspitze können insbesondere gemeinsam aus dem Wafer herausgearbeitet oder getrennt gefertigt und anschließend zusammengefügt sein. Je nach dem Fertigungsverfahren sind im Halteelement Schichten unterschiedlicher Materialien wie z. B. Siliziumdioxid, Siliziumnitrit oder andere enthalten. Dies ist in die Erfindung eingeschlossen, sofern einkristallines Silizium den überwiegenden Anteil des Materials des Halteelementes bildet.

Mit der Erfindung wird die Packungsdichte der Sonden im Waferverbund gegenüber dem Stand der Technik erheblich vergrößert, so dass eine um etwa fünfzig bis siebzig Prozent erhöhte Anzahl von Siliziumsonden aus einem Wafer mit gleicher Größe produziert werden kann. Dies mindert die Stückkosten für eine derartige Sonde deutlich.

Bei dem erfindungsgemäßen Verfahren zur Herstellung des vorstehend beschriebenen Waferverbundes mit Sonden für die Rasterkraftmikroskopie wird als Ausgangsmaterial einkristallines Silizium mit einer {100}-Oberfläche verwendet. Dabei werden die Halteelemente durch ein anisotropes, kristallorientierungsabhängiges nasschemisches Ätzverfahren erzeugt, das eine geringe Ätzrate bezüglich der <111>-Richtungen des Siliziumwafers aufweist. Hierbei wird der Abstand zwischen den verbundenen Halteelementen der Sonden so gewählt, dass in den Zwischenräumen V-förmige Kerben entstehen, deren Seitenflanken von {111}-Flächen des Siliziumwafers gebildet werden und deren Tiefe aufgrund des Ätzverfahrens und durch die gewählten Abstände zwischen den Halteelementen selbstlimitierend ist. Außerdem wird der Abstand zwischen dem Haltelement der äußeren Sonden der Sondenstreifen und dem Waferrahmen auch derart gewählt, dass sich dazwischen ebenfalls entsprechende V-förmige Kerben ergeben. Das verwendete nasschemische Ätzverfahren ist aus dem Stand der Technik dem Fachmann wohlbekannt. Es braucht daher an dieser Stelle nicht weiter erläutert zu werden.

Nachfolgend wird die Erfindung anhand eines in der Zeichnung dargestellten Ausführungsbeispiels näher erläutert. Weitere Merkmale der Erfindung ergeben sich aus der folgenden Beschreibung des Ausführungsbeispiels der Erfindung in Verbindung mit den Ansprüchen und der beigefügten Zeichnung. Die einzelnen Merkmale der Erfindung können für sich allein oder zu mehreren bei unterschiedlichen Ausführungsformen der Erfindung verwirklicht sein. Es zeigen:
- Figur 1: einen erfindungsgemäßen Waferverbund mit in Quer- und in Längsreihen angeordneten Sondenstreifen, die zumindest teilweise eine unterschiedliche Anzahl von Sonden umfassen;
- Figur 2: eine Detailansicht der Sonden der Sondenstreifen aus Figur 1;
- Figur 3: einen Sondenstreifen aus Figur 1 mit fünf Sonden in Draufsicht, und
- Figur 4: den Sondenstreifen aus Figur 3 in einer Längsschnittdarstellung.

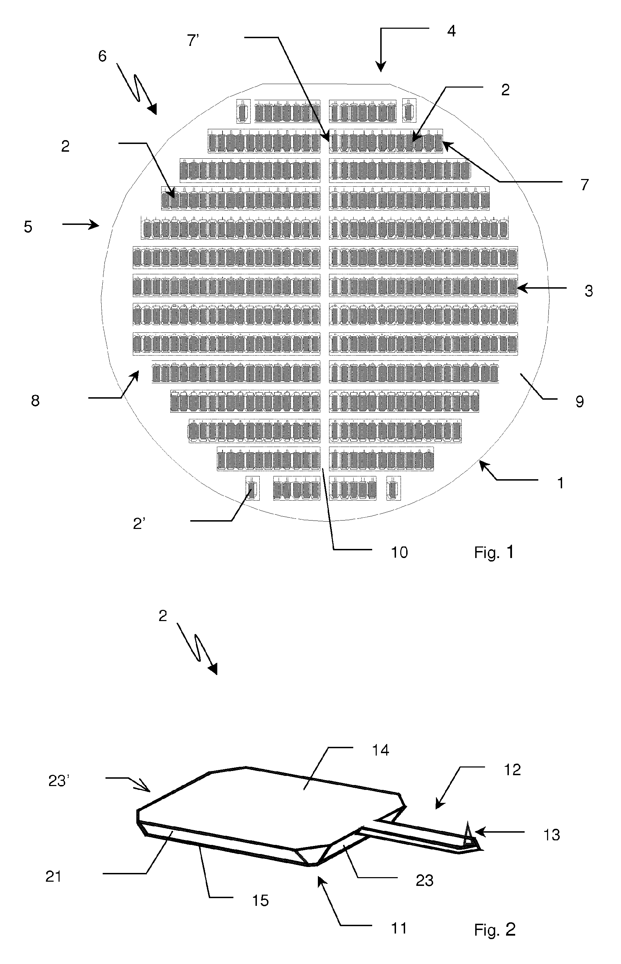

Figur 1 zeigt einen erfindungsgemäßen Waferverbund 1 mit einer Vielzahl von Sonden 2, 2' für die Rasterkraftmikroskopie, wobei jeweils eine Anzahl von Sonden 2 zu Sondenstreifen 3 zusammengefasst sind. Die Sondenstreifen 3 haben teilweise eine unterschiedliche Länge, d. h. sie umfassen eine unterschiedliche Anzahl von gruppierten Sonden 2. Die Sondenstreifen 3 sind in Streifenquerrichtung parallel zueinander und in Streifenlängsrichtung fluchtend miteinander beabstandet voneinander in zwei Querreihen 4 und 14 Längsreihen 5 auf einem Siliziumwafer 6 angeordnet. Die Sondenstreifen 3 sind mit ihren Enden 7, 7' mit einem Waferrahmen 8 herausbrechbar verbunden, der aus einem umlaufenden Waferrand 9 und einem sich mittig als Kreissehne erstreckenden Waferzwischensteg 10 besteht. Das Ende 7 der Sondenstreifen 3 ist mit dem Waferrahmen 9 und das andere Ende 7' der Sonden 2 mit dem Waferzwischensteg 10 verbunden. Der Waferverbund 1 weist außer den Sondenstreifen 3 mehrere einzelne Sonden 2' für die Prozesskontrolle auf, die ähnlich wie die äußeren Sonden 2 der Sondenstreifen 3 mit dem Waferrahmen 8 herausbrechbar verbunden sind.

Die Figur 2 zeigt eine Sonde 2 aus den Sondenstreifen 3 in vergrößerter perspektivischer Darstellung. Die Sonde 2 umfasst ein Halteelement 11, einen Federbiegebalken 12 und eine Abtastspitze 13, die von dem Federbiegebalken 12 getragen ist. Das Halteelement 11 ist mit einer im wesentlichen trapezförmigen Querschnittsform ausgebildet und weist eine einer abzutastenden Probe zugeordnete Unterseite 14 auf, an der auch der Federbiegebalken 12 mit der Abtastspitze 13 angeordnet ist, sowie eine der Unterseite 14 mit Abstand gegenüberliegende Oberseite 15 auf. Von der Oberseite 15 zu der Unterseite 14 erstrecken sich Längsseitenflanken 21, die in der Figur nicht gezeigte Bruchkanten aufweisen.

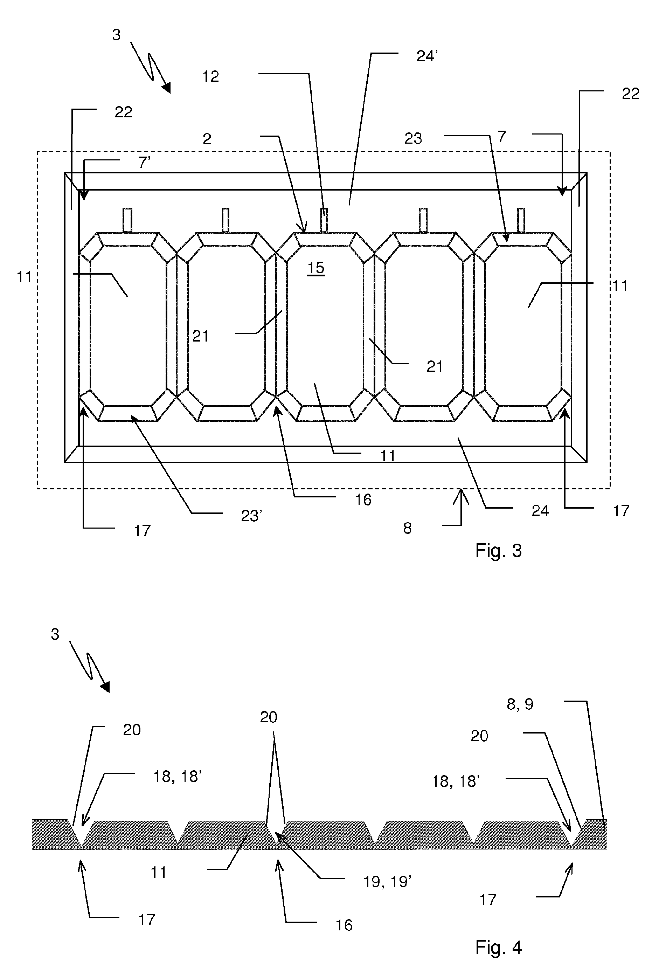

Die Figur 3 zeigt einen Sondenstreifen 3 aus Figur 1, bei dem fünf Sonden 2 gruppiert sind, mit Blick auf die Oberseite 15. Die Abtastspitzen 13 sind auf der der Oberseite 15 abgewandten Unterseite 14 angeordnet und daher in dieser Ansicht nicht sichtbar. Die fünf Halteelemente 11 sind untereinander über jeweils eine Anbindung 16 miteinander verbunden. Die beiden äußeren Halteelemente 11 des Sondenstreifens 3 sind mit dem Waferrahmen 8 über je eine Halterung 17 herausbrechbar verbunden. Die Halterungen 17 weisen Sollbruchstellen 18' in Form von V-förmigen Kerben 18 und die Anbindungen 16 Sollbruchstellen 19' in Form von V-förmigen Kerben 19 auf. Die Kerben 18, 19 sind, wie die Figur 4 deutlicher zeigt, mit Kerbenflanken 20 ausgebildet, die von {111}-Ebenen des Siliziumwafers 8 gebildet sind. Die Kerbenflanken 20 bilden zudem die Längsseitenflanken 21 der Halteelemente 11 und die Querseitenflanken 22 des Waferzwischensteges 10 sowie des umlaufenden Waferrandes 9. Zwischen vorderen bzw. hinteren Querseitenflanken 23, 23' der Halteelemente 11 und dem Waferrahmen 8 sind Freiräume 24, 24' vorgesehen, so dass der jeweilige Sondenstreifen 3 lediglich über die Sollbruchstellen 18' mit dem Waferrahmen 8 verbunden ist. Die in der Figur 1 gezeigten einzelnen Sonden 2' sind ähnlich den äußeren Sonden 2 der Sondenstreifen 3 über eine Halterung 17 mit Sollbruchstelle 18' mit dem Waferrahmen 8 verbunden ist

Figur 4 zeigt den in der Figur 3 abgebildeten Sondenstreifen 3 in einer Längsschnittdarstellung. Deutlich zu erkennen sind jetzt die V-förmigen Kerben 18, 19 und die Sollbruchstellen 18', 19' zwischen den Halteelementen 11 des Sondenstreifens 3 bzw. dem Sondenstreifen 3 und dem Waferrahmen 8 angeordnet sind. Die Spitzen der V-förmigen Kerben 18, 19 definieren die Sollbruchstellen 18', 19' der Halterungen 17 bzw. der Anbindungen 16. Die randseitigen Kerben 18, die sich zwischen den äußeren Haltelementen 11 des Sondenstreifens 3 und dem Waferrahmen 8 erstrecken, sind breiter und tiefer ausgebildet als die innenliegenden Kerben 19, die zwischen den Halteelementen 11 der Sonden 2 verlaufen. Damit ist die benötigte Kraft zum Herausbrechen der Sondenstreifen 3 aus dem Sondenrahmen 8 deutlich geringer als die Kraft die benötigt wird, um die Sonden 2 aus dem Sondenstreifen 3 zu vereinzeln.

## Patentansprüche

1. Waferverbund (1) mit Sonden (2, 2') für ein Rasterkraftmikroskop, worin eine Vielzahl von Sonden (2, 2'), die jeweils ein Halteelement (11) und einen von dem Halteelement (11) abstehenden, eine Abtastspitze (13) tragenden Federbiegebalken (12) aufweisen, in einem regelmäßig strukturierten Waferrahmen (8) herausbrechbar angeordnet sind, wobei zumindest die Haltelemente (11) aus einem Siliziumwafer (6) herausgearbeitet und die Sonden (2, 2') über die Halteelemente (11) direkt oder indirekt mit dem Waferrahmen (8) über mindestens eine Halterung (17) verbunden sind, die eine Sollbruchstelle (18') zum mechanischen Lösen der Sonden (2, 2') von dem die Sonden (2, 2') umgebenden Waferrahmen (8) aufweist, wobei
- die Halteelemente (11) überwiegend einkristallines Silizium aufweisen,
**dadurch gekennzeichnet, dass**
- die Halteelemente (11) von jeweils mindestens zwei nebeneinander angeordneten Sonden (2) zur Bildung von Sondenstreifen (3) über jeweils eine direkte Anbindung (16) miteinander verbunden sind, die eine exakt definierte Sollbruchstelle (19') aufweist,
- die Halteelemente (11) der äußeren Sonden (2) der Sondenstreifen (3) über Halterungen (17) mit exakt definierten Sollbruchstellen (18'), direkt mit dem Waferrahmen (8) verbunden sind, und
- die exakt definierten Sollbruchstellen (19') der Anbindungen (16) und die exakt definierten Sollbruchstellen (18') der Halterungen (17) derart ausgelegt sind, dass die Sollbruchstellen (18') der Halterungen (17) leichter brechen als die Sollbruchstellen (19') der Anbindungen (16).

2. Waferverbund nach Anspruch 1, **dadurch gekennzeichnet, dass** die Anbindungen (16) eine V-förmige Kerbe (19) als Sollbruchstellen (19') aufweisen.

3. Waferverbund nach Anspruch 1, **dadurch gekennzeichnet, dass** die Halterungen (17) eine oder mehrere V-förmige Kerben (18) als Sollbruchstellen (18') aufweisen.

4. Waferverbund nach Anspruch 2 und 3, wobei die Anbindungen (16) eine V-förmige Kerbe (19) als Sollbruchstellen (19') und die Halterungen (17) eine V-förmige Kerbe (18) als Sollbruchstellen (18') aufweisen, **dadurch gekennzeichnet, dass** die Kerben (18) der Halterungen (17) tiefer und breiter sind als die Kerben (19) der Anbindungen (16).

5. Waferverbund nach Anspruch 2 und 3, wobei die Anbindungen (16) eine V-förmige Kerbe (19) als Sollbruchstellen (19') und die Halterungen (17) mehrere V-förmige Kerben (18) als Sollbruchstellen (18') aufweisen, **dadurch gekennzeichnet, dass** die Kerben (18) der Halterungen (17) gleich oder weniger tief und/oder breit sind als die Kerben (19) der Anbindungen (16).

6. Waferverbund nach einem der vorstehenden Ansprüche 2 bis 5, **dadurch gekennzeichnet, dass** die Kerben (18, 19) Kerbenflanken (20) aufweisen, die von {111}-Ebenen des Siliziumwafers (6) gebildet sind.

7. Waferverbund nach einem der vorstehenden Ansprüche, **dadurch gekennzeichnet, dass** die Sondenstreifen (3) zumindest teilweise eine unterschiedliche Anzahl von Sonden (2) aufweisen.

8. Waferverbund nach einem der vorstehenden Ansprüche, **dadurch gekennzeichnet, dass** der Waferverbund (1) außer den Sondenstreifen (3) mindestens eine einzelne Sonde (2') für die Prozesskontrolle aufweist, die über eine Halterung (17) mit Sollbruchstelle (18') mit dem Waferrahmen (8) verbunden ist.

9. Verfahren zur Herstellung eines Waferverbundes (1) mit Sonden (2, 2') für ein Rasterkraftmikroskop nach einem der vorangegangenen Ansprüche, **dadurch gekennzeichnet, dass**
- als Ausgangsmaterial einkristallines Silizium mit einer {100}-Oberfläche verwendet wird,
- die Halteelemente (11) durch ein anisotropes, kristallorientierungsabhängiges nasschemisches Ätzverfahren erzeugt werden, das eine geringere Ätzrate bezüglich der <111>-Richtungen des Siliziumwafers (6) aufweist,
- der Abstand zwischen den verbundenen Halteelementen (11) der Sondenstreifen (3) so gewählt ist, dass dazwischen V-förmige Kerben (19) als Anbindungen (16) mit exakt definierten Sollbruchstellen (19') entstehen, und/oder
- der Abstand zwischen dem Haltelementen (11) der äußeren Sonden (2) der Sondenstreifen (3) und dem Waferrahmen (8) derart gewählt ist, dass sich dazwischen V-förmige Kerben (18) als Halterungen (17) mit exakt definierten Sollbruchstellen (18') ergeben, und
- die V-förmige Kerben (19) der Anbindungen (16) und die V-förmige Kerben (18) der Halterungen (17) derart ausgelegt werden, dass die Sollbruchstellen (18') der Halterungen (17) leichter brechen als die Sollbruchstellen (19') der Anbindungen (16).

10. Verfahren nach Anspruch 9, **dadurch gekennzeichnet, dass** die Kerben (18, 19) Seitenflanken (20) aufweisen, die von {111}-Ebenen des Siliziumwafers (6) gebildet werden und deren Tiefe aufgrund des Ätzverfahrens und durch die gewählten Abstände zwischen den Halteelementen (11) selbstlimitierend ist.

## Claims

1. Wafer assembly (1) having probes (2, 2') for a scanning force microscope, wherein a multiplicity of probes (2, 2'), which each have a holding element (11) and a spring cantilever (12) that projects from the holding element (11) and carries a scanning tip (13), are arranged in a regularly structured wafer frame (8) so as to be capable of being broken off, wherein at least the holding elements (11) being formed out of a silicon wafer (6) and the probes (2, 2') being connected via the holding elements (11) directly or indirectly to the wafer frame (8) via at least one connector (17) which has a predetermined breaking point (18') for mechanical detachment of the probes (2, 2') from the wafer frame (8) surrounding the probes (2, 2'), wherein the holding elements (11) comprise predominantly monocrystalline silicon, **characterised in that**
- the holding elements (11) of at least two probes (2) being arranged one next to the other are connected to one another to form probe strips (3) in each case via a direct connection (16) which has an exactly defined predetermined breaking point (19'),
- the holding elements (11) of the outer probes (2) of the probe strips (3) are connected directly to the wafer frame (8) via connectors (17) having exactly defined predetermined breaking points (18'), and
- the exactly defined predetermined breaking points (19') of the connections (16) and the exactly defined predetermined breaking points (18') of the connectors (17) are designed in such a way that the predetermined breaking points (18') of the connectors (17) break more easily than do the predetermined breaking points (19') of the connections (16).

2. Wafer assembly according to claim 1, **characterised in that** the connections (16) have a V-shaped groove (19) as predetermined breaking points (19').

3. Wafer assembly according to claim 1, **characterised in that** the connectors (17) have one or more V-shaped grooves (18) as predetermined breaking points (18').

4. Wafer assembly according to claims 2 and 3, wherein the connections (16) have a V-shaped groove (19) as predetermined breaking points (19') and the connectors (17) have a V-shaped groove (18) as predetermined breaking points (18'), **characterised in that** the grooves (18) of the connectors (17) are deeper and wider than the grooves (19) of the connections (16).

5. Wafer assembly according to claims 2 and 3, wherein the connections (16) have a V-shaped groove (19) as predetermined breaking points (19') and the connectors (17) have a plurality of V-shaped grooves (18) as predetermined breaking points (18'), **characterised in that** the grooves (18) of the connectors (17) are equal or are less deep and/or wide than the grooves (19) of the connections (16).

6. Wafer assembly according to any one of preceding claims 2 to 5, **characterised in that** the grooves (18, 19) have groove flanks (20) that are formed by {111}-planes of the silicon wafer (6).

7. Wafer assembly according to any one of the preceding claims, **characterised in that** at least some of the probe strips (3) have a different number of probes (2).

8. Wafer assembly according to any one of the preceding claims, **characterised in that** the wafer assembly (1), besides having the probe strips (3), has at least one individual probe (2') for process control, which probe is connected to the wafer frame (8) via a connector (17) having a predetermined breaking point (18').

9. Process for the production of a wafer assembly (1) having probes (2, 2') for a scanning force microscope according to any one of the preceding claims, **characterised in that**
- monocrystalline silicon having a {100}-surface is used as starting material,
- the holding elements (11) are created by an anisotropic, crystal-orientation-dependent wet-chemical etching process which has a relatively low etching rate in respect of the <111>-directions of the silicon wafer (6),
- the spacing between the connected holding elements (11) of the probe strips (3) is chosen so that there are formed between them V-shaped grooves (19) as connections (16) having exactly defined predetermined breaking points (19'), and/or
- the spacing between the holding elements (11) of the outer probes (2) of the probe strips (3) and the wafer frame (8) is chosen in such a way that there are produced between them V-shaped grooves (18) as connectors (17) having exactly defined predetermined breaking points (18'), and
- the V-shaped grooves (19) of the connections (16) and the V-shaped grooves (18) of the connectors (17) are designed in such a way that the predetermined breaking points (18') of the connectors (17) break more easily than do the predetermined breaking points (19') of the connections (16).

10. Process according to claim 9, **characterised in that** the grooves (18, 19) have side flanks (20) which are formed by {111}-planes of the silicon wafer (6) and the depth of which is self-limiting by virtue of the etching process and as a result of the chosen spacings between the holding elements (11).

## Revendications

1. Ensemble plaquette (1) muni de sondes (2, 2') pour un microscope à force atomique, dans laquelle une pluralité de sondes (2, 2'), qui présentent chacune un élément de maintien (11) et une poutre élastique en flexion (12) faisant saillie de l'élément de maintien (11) et portant une pointe d'exploration (13), sont disposées de manière détachable dans un cadre de plaquette (8) régulièrement structuré, au moins les éléments de maintien (11) étant produits à partir d'une plaquette en silicium (6) et les sondes (2, 2') étant reliées par les éléments de maintien (11) directement ou indirectement au cadre de plaquette (8) par l'intermédiaire d'au moins un support (17) qui présente une zone de rupture prévue (18') pour la séparation mécanique des sondes (2, 2') du cadre de plaquette (8) qui entoure les sondes (2, 2'), les éléments de maintien (11) présentant principalement du silicium monocristallin,
**caractérisé en ce que**
- les éléments de maintien (11) de chaque fois au moins deux sondes (2) disposée côte à côte sont reliées entre eux par une liaison directe (16), qui présente une zone de rupture prévue (19') exactement définie, pour former des bandes de sondes (3),
- les éléments de maintien (11) des sondes extérieures (2) des bandes de sondes (3) sont reliés directement au cadre de plaquette (8) par des supports (17) présentant des zones de rupture prévue (18') exactement définies, et
- les zones de rupture prévue (19') exactement définies des liaisons (16) et les zones de rupture prévue (18') exactement définies des supports (17) sont conçues de façon que les zones de rupture prévue (18') des supports (17) se rompent plus facilement que les zones de rupture prévue (19') des liaisons (16).

2. Ensemble plaquette selon la revendication 1, **caractérisé en ce que** les liaisons (16) présentent une entaille en forme de V (19) en tant que zones de rupture prévue (19').

3. Ensemble plaquette selon la revendication 1, **caractérisé en ce que** les supports (17) présentent une ou plusieurs entailles en forme de V (18) en tant que zones de rupture prévue (18').

4. Ensemble plaquette selon les revendication 2 et 3, dans lequel les liaisons (16) présentent une entaille en forme de V (19) en tant que zones de rupture prévue (19') et les supports (17) une entaille en forme de V (18) en tant que zones de rupture prévue (18'), **caractérisé en ce que** les entailles (18) des supports (17) sont plus profondes et plus larges que les entailles (19) des liaisons (16).

5. Ensemble plaquette selon les revendications 2 et 3, dans lequel les liaisons (16) présentent une entaille en forme de V (19) en tant que zones de rupture prévue (19') et les supports (17) plusieurs entailles en forme de V (18) en tant que zones de rupture prévue (18'), **caractérisé en ce que** les entailles (18) des supports (17) sont aussi ou moins profondes et/ou larges que les entailles (19) des liaisons (16).

6. Ensemble plaquette selon l'une des revendications précédentes 2 à 5, **caractérisé en ce que** les entailles (18, 19) présentent des flancs d'entaille (20) qui sont formés par des plans {111} de la plaquette de silicium (6).

7. Ensemble plaquette selon l'une des revendications précédentes, **caractérisé en ce que** les bandes de sondes (3) présentent au moins en partie un nombre différent de sondes (2).

8. Ensemble plaquette selon l'une des revendications précédentes, **caractérisé en ce que** l'ensemble plaquette (1) présente, outre les bandes de sondes (3), au moins une sonde (2') individuelle pour le contrôle du processus, qui est reliée au cadre de plaquette (8) par un support (17) présentant une zone de rupture prévue (18').

9. Procédé de fabrication d'un ensemble plaquette (1) muni de sondes (2, 2') pour un microscope à force atomique selon l'une des revendications précédentes, **caractérisé en ce que**
- du silicium monocristallin avec une surface {100} est utilisé comme matériau de départ,
- les éléments de maintien (11) sont produits par un procédé d'attaque chimique par voie humide anisotrope, dépendant de l'orientation cristallographique, qui présente une vitesse d'attaque plus faible en ce qui concerne la direction <111> de la plaquette de silicium (6),
- la distance entre les éléments de maintien (11) reliés des bandes de sondes (3) est choisie de façon que soient formées entre eux des entailles en forme de V (19) en tant que liaisons (16) présentant des zones de rupture prévue (19') exactement définies, et/ou
- la distance entre l'élément de maintien (11) des sondes extérieures (2) des bandes de sondes (3) et le cadre de plaquette (8) est choisie de façon que soient formées entre eux des entailles en forme de V (18) en tant que supports (17) présentant des zones de rupture prévue (18') exactement définies, et
- les entailles en forme de V (19) des liaisons (16) et les entailles en forme de V (18) des supports (17) sont conçues de façon que les zones de rupture prévue (18') des supports (17) se rompent plus facilement que les zones de rupture prévue (19') des liaisons (16).

10. Procédé selon la revendication 9, **caractérisé en ce que** les entailles (18, 19) présentent des flancs latéraux (20) qui sont formés par des plans {111} de la plaquette de silicium (6) et dont la profondeur est autolimitante en raison du procédé d'attaque et des distances choisies entre les éléments de maintien (11).
